# EUROPEAN PATENT SPECIFICATION

(11) **EP 1 086 526 B1**
(45) Date of publication and mention of the grant of the patent: **25.06.2003**
(21) Application number: 99916815.6
(22) Date of filing: 11.05.1999
(51) Int. Cl.: H03F 1/56

(54) **Circuit and its use for reducing distortions and noise of square-wave pulses**
Schaltung und deren Verwendung zur Reduzierung von Verzerrungen und Störungen von Rechteckimpulsen
Circuit et l'application de ce dernier pour réduire les distortions et les bruits des impulsions rectangulaires

(30) Priority: 11.05.1998 DK 64198
(43) Date of publication of application: 28.03.2001
(73) Proprietor: Texas Instruments, Copenhagen APS, 2400 Copenhagen NV (DK)
(72) Inventor: ANDERSKOUV, Niels, DK-1651 Copenhagen V (DK); RISBO, Lars, DK-2300 Copenhagen S (DK)
(74) Representative: Plougmann & Vingtoft A/S
(86) International application number: DK9900261
(87) International publication number: WO99059241

(56) References cited:
- US-A- 5 163 174
- US-A- 5 506 532
- US-A- 5 917 369
- S.CUK AND R.ERICKSON: "A conceptually new high-frequency switched-mode power amplifier technique eliminates current ripple", 06. May 7978, FIFTH NATIONAL SOLID-STATE POWER CONVERSION CONFERENCE, SAN FRANCISCO

## Description

The invention relates to a circuit as defined in the preamble of present claim 2 and to the use of a circuit as defined in the preamble of present claim 1.

Traditional switched circuits for use for power electronics require a certain dead time to avoid great destructive connecting and disconnecting currents, partly to restrict switching losses in the half-bridge incorporated in the circuit and partly to eliminate ringings on the output signal with out adding a parallel snubber and thereby increased losses.

Addition of dead time in switched circuits used in amplifiers and particularly in class D amplifiers for HI-FI, however, involves an intolerable distortion of the modulated output signals. Therefore, it has long been attempted to find a principle which allows dead time in half-bridges to be reduced without bringing about the above-mentioned drawbacks.

The principle of a switched amplifier is that one or more switches in a switched circuit of the two-port type or a multiple thereof is switched to conduct and non-conduct, respectively, e.g. by pulse-width or pulse-density modulation, depending on the amplitude of a signal, such as an audio signal.

Hereby, the information of the audio signal is converted into a number of pulses which exactly correspond to the information of the audio signal.

The primary advantage of pulse-modulated amplifiers is a very high efficiency, which theoretically is 100%, which means that, theoretically, the amplifier has no loss. In practical realisations of pulse-modulated amplifiers, typical efficiencies of between 90 and 98% may be achieved. Pulse-modulated amplifiers are also totally linear in theory and thereby have a very low distortion, but in practice it has been found that non-linearities have caused them to be unsuitable for use in High Fidelity amplifiers for audio. The reason is primarily that it is not possible to provide ideal square-wave pulses in the switched circuit, due to the use of switches that are not ideal having parasitic capacitive and inductive components around the switch element.

One of the main reasons why the pulses cannot be generated ideally is inter alia to be found in the connection and disconnection of the switches. The pulse widths vary as a consequence of variations in the turn-on and turn-off times of the switches, while the necessary dead time between connection and disconnection of the two switches is kept constant. The variations in the turn on and turn off times is due to several factors, among which the most important is the varying load current and variations in the characteristics of the components used in and around the output stage. The most important variations in the component characteristics is due to variations in temperature but also varying component characteristics due to different batches and eldering phenomena's are known as important issues that must be taken care of. It is therefore desirable to reduce the turn-on and turn-off times and thereby the dead time to a minimum in pulse-modulated power amplifiers.

Conversely, reduced turn-on and turn-off times as well as less dead time causes problems of increased power consumption, and consequent destructive peak currents in the switches and strong ringing on the output signal, as both switches will briefly be turned on simultaneously.

Moreover, it is known that the pulse heights vary because of the ringing which occurs when connecting and disconnecting the load current, which causes distortion of the audio signal.

Such ringing may be partly limited by establishing a parallel snubber circuit of a known type over the switches which attenuates the oscillations that occur because of the parasitic inductance's and capacities of the switching circuit. The drawback of such a circuit, however, is that the turn-on and turn-off times are increased, and that the switching losses and thereby the idle loss of the amplifier are increased, so that the efficiency of the amplifier is reduced and the pulse-width distortion is increased.

Existing practical realisations nevertheless use parallel snubber circuits, as the ringing in and around switched circuits means that the circuits emit so strong high-frequency signals that the circuits cannot be used according to the current standards in the field.

The known methods of generating square-wave pulses in switched amplifiers thus involve distortion of the modulated signal. These methods are particularly not suitable for use in switched amplifiers, e.g. class D amplifiers for HI-FI, where design criteria, such as low distortion, low noise and high efficiency, are important.

There are two categories of switched amplifiers for audio. One category is switched amplifiers having analogue input signals. The other category is switched amplifiers having digital input signals.

The latter amplifier exclusively operates in the digital domain, and is therefore called full digital power amplifier.

Particularly in the full digital power amplifier it is important to be able to generate approximately ideal square-wave pulses, as the distortion-reducing feedback around the output stage cannot be realised, without having to leave the digital domain.

This makes very strict demands on the linearity of the output stage and thereby on the generation of the square-wave pulses with a minimal distortion and noise.

Accordingly, it is an object of the invention to provide a circuit capable of generating minimally distorted square-wave pulses with minimum noise and minimum losses in the output stage and of reducing the peak current during the switching sequences in the switched circuit.

The object of the invention is achieved by a circuit as defined in claim 7.

The circuit thus has the advantage that the high-frequency ringing, which normally occurs because of parasitic inductance's and capacities in the switched circuit, may be attenuated significantly by the resistive damping.

The resistive behaviour of the noise attenuating circuit at high frequencies also has the advantage that transient peak currents in the switched circuit may be reduced to a maximum value event by short-circuit of the switching contacts. The dead time may therefore be reduced to a minimum, without generating destructive current in the switches or pulse height errors in the form of strong ringing on the output signal originating from strong short-circuit currents.

When the correction circuit block has a set of input terminals to which a single or double voltage supply is applied, and a series coupling of an inductance and a load circuit is applied to the switchable port of the switching circuit block, it is ensured that a Buck converter may be produced, approximately capable of generating ideal square-wave pulses of minimum distortion and noise in the form of minimum dead time and ringing in the switched circuit, while the peak current in the switches in the switched circuit may be limited to a maximum value.

As mentioned, the invention also relates to the use of a circuit.

This use of a circuit is defined in claim 1.

The predominantly resistive impedance at high frequencies provides the advantage that the circuit serves as a current limiter during the transient switching sequences in the switched circuit, thereby allowing a minimum dead time to be maintained. The predominantly resistive behaviour of the noise attenuating circuit at high frequencies additionally has the advantage that the high-frequency ringing which normally occurs because of parasitic inductances and capacities in the switched circuit is attenuated considerably. Compared to parallel snubber circuits where the same can be achieved this circuit has less losses, due to there is no parallel capacitor that must be voltage shifted by the switches.

When, as stated in claim 3, the correction circuit block comprises an inductive component which is connected to a series connection of a capacitive and a resistive component, a very simple circuit structure having only three components is obtained.

When, as stated in claim 5, a resistive component is connected in parallel with the inductive component, it is ensured that the value of the resistor in the series coupling of the capacitor and the resistor may be increased, as the two resistors form an AC parallel coupling.

As stated in claim 6, it is expedient that the values of the capacitive and the inductive components of the network are at least four times greater than the values of parasitic capacitive and inductive components of the switching circuit.

When the resistive value of the correction circuit block at high frequencies is twice the characteristic impedance of the overall parasitic inductance and the overall parasitic capacitance of the switching circuit, a strong attenuation of the inevitably occurring oscillations is achieved, which means that dead time between as well as turn-on and turn-off rates of the switches in the switched circuit may be reduced to a minimum, without the occurrence of strong ringings which would otherwise have caused distortion and noise and possible destruction of the switches.

The distortion of the square-wave pulses may be reduced additionally in that an already known snubber circuit consisting of a series connection of a capacitor and a resistor is connected in parallel with the switchable port of the switching circuit block.

The circuit exhibits particularly reduced distortion when used in switched circuits having relatively great parasitic inductances. The addition of the parallel snubber circuits may advantageously be performed in switched circuit designs where the characteristic impedance of parasitic inductances and capacities is great, which may occur e.g. in layouts of large dimensions.

As stated in claim 7 the correction circuit block and the switching circuit block are formed as an integrated unit on a substrate.
This means that the parasitic inductances and the distortion in the half-bridge are reduced additionally.

When, as stated in claim 9, the series connection of the capacitive (14) and resistive (15) components is formed by a capacitor and its internal series resistance, it is ensured that the circuit may be realized in a very simple manner.

Expedient embodiments of the invention are defined in the dependent claims.

Thus, in class D amplifiers and power supplies, it is possible to provide a limitation in the peak current in the switches, and a much simpler reduction in noise, distortion and ringing in the switched circuits incorporated therein, than is possible to achieve in traditionally used filterings in switched circuits.

The invention will now be explained more fully with reference to an embodiment of the invention shown in the drawing, in which
fig. 1 shows the basic structure of the invention in block diagram form,
fig. 2 shows examples of uses of the invention in block diagram form,
fig. 3 shows an example of a switched circuit of the two-port type in the fig. 1 basic structure,
fig. 4 shows an example of a two-port network in diagram form in the fig. 1 basic structure according to the invention,
fig. 5 shows an example of a second circuit in diagram form in the fig. 1 basic structure according to the invention,
fig. 6 shows the course of a voltage in the circuit during and after a switching sequence,
fig. 7 shows a course of a voltage in the circuit which constitutes the invention,
fig. 8 shows an example of a noise attenuating circuit in diagram form in the fig. 1 basic structure,
fig. 9 shows another example of a noise attenuating circuit in diagram form in the fig. 1 basic structure,
fig. 10 shows an example in diagram form of how a single voltage supply may be connected to the noise attenuating circuit,
fig. 11 shows an example in diagram form of how a double voltage supply may be connected to the noise attenuating circuit in the fig. 2 diagram,
fig. 12 shows an example in diagram form of how a load may be connected to the noise attenuating circuit in yhe fig.2 diagram.
fig. 13 shows an example of how the circuits 1 and 2 in fig. 1 may be realised.
fig. 14a - 14g shows different states of current flows in the circuits 1 and 2 showed in figure 13.
fig. 15a - 15b shows different states in current flow of the circuits 1 and 2 at low frequencies.
fig. 16a - 16b shows different states in current flow of the circuits 1 and 2 at very high frequencies.

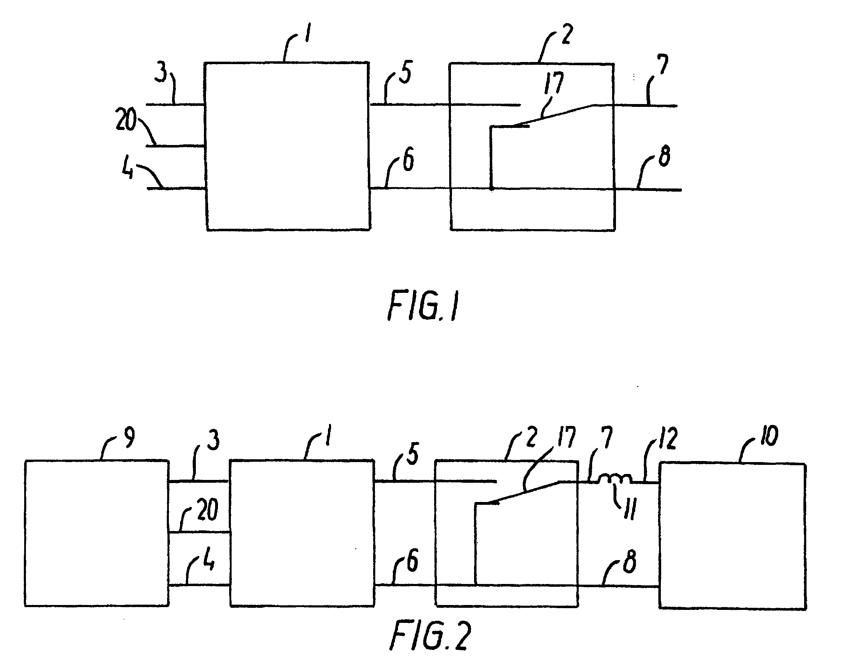

In figure 1, the numeral 1 designates a circuit which is connected to a switched circuit of the two-port type 2 via two terminals 5 and 6. The switched circuit is formed by a two-port, in which the terminals 6 and 8 are interconnected, and one port accommodates a switching terminal 7 which is connected to a switch 17 capable of being switched between the two terminals 5 and 6 of the other port. The short-circuit impedance (with terminals 3, 4 and 20 short-circuited) of the circuit 1, seen from the port containing the terminals 5 and 6, is characteristic by being low at low frequencies and high and predominantly resistive at high frequencies.

Figure 2 shows examples of the use of the circuit 1 and the switched circuit 2, in which the terminals 3, 4 and 20 of the circuit 1 are connected to a circuit 9, and in which the terminal 7 of the switched circuit is connected to a series coupling of an inductance 11 and a circuit 10 which is connected to the terminal 8. The circuits 9 and 10 may e.g. be given by a voltage supply 9 and a load 10, whereby the circuit 1 and the switched circuit 2 are incorporated in a configuration which is known as a Buck converter from the literature. Correspondingly, the circuits 9 and 10 may be given by a load 9 and a voltage supply 10, whereby the circuit and the switched circuit are incorporated in a configuration which is known as a Boost converter.

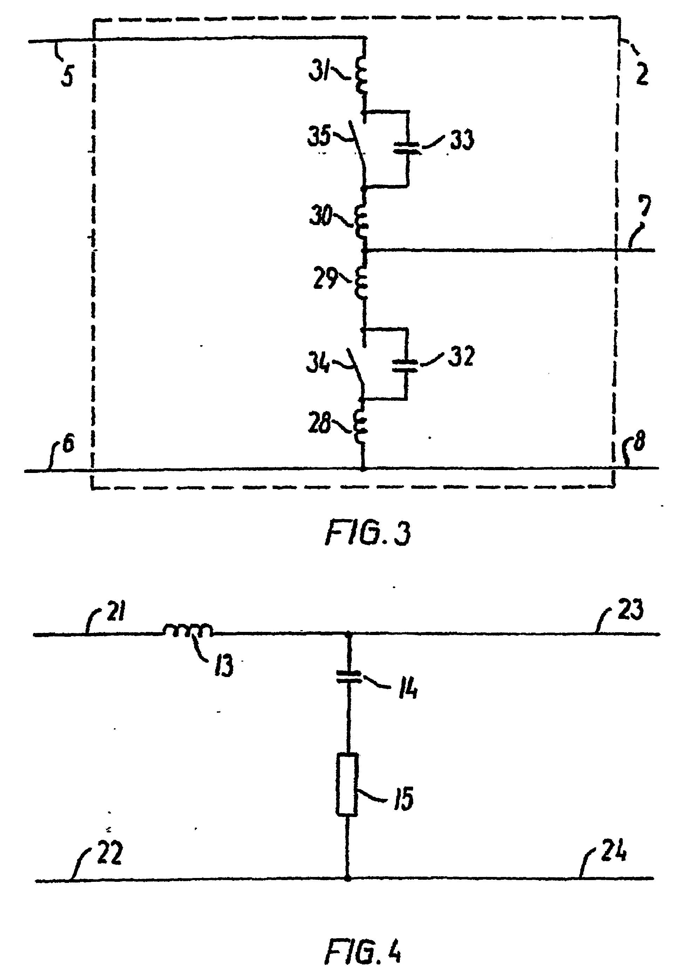

Figure 3 shows an example of a simplified switched circuit 2 of the two-port type, in which the parasitic components are also shown. One port accommodates a switchable terminal 7 which may be switched between the terminals 5 and 6 of the other port of fig.1 or 2.
The terminals 6 and 8 of the ports are shown to be interconnected. The parasitic components of the switched circuit are drawn around the switches 34, 35. The parasitic inductances 28 and 31 occur between the terminals 5 and 6, and the switches 34 and 35 and the value of the inductances are primarily determined by layout and die mounting technique. The parasitic inductances 29 and 30 are provided between the terminal 7 and the switches 34 and 35, and the value of these inductances is likewise primarily determined by layout and die mounting technique.

Parasitic capacities 32 and 33 are provided in parallel with the switches 34 and 35, and the value of these capacities is determined by the manufacturing method used by the component supplier.

The parasitic capacities and inductances thus form an oscillation circuit, which is turned on by the switching terminal 7 between the terminals 5 and 6, which causes ringings on the terminals of the switched circuit. These ringings may be attenuated considerably by connecting the circuit 1 to the terminals 5 and 6. The switches in figure 3 are illustrated by two force-commutated contacts (transistors), but may also be formed by a force-commutated and a non-force-commutated contact (e.g. a diode).

Figure 4 shows an example of how the circuit 1 may be realized as a two-port network. The inductance 13 of the circuit is shown to be connected between the terminals 21 and 23, and the series coupling of the capacitor 14 and the resistor 15 of the circuit is shown to be connected between the terminals 23 and 24.

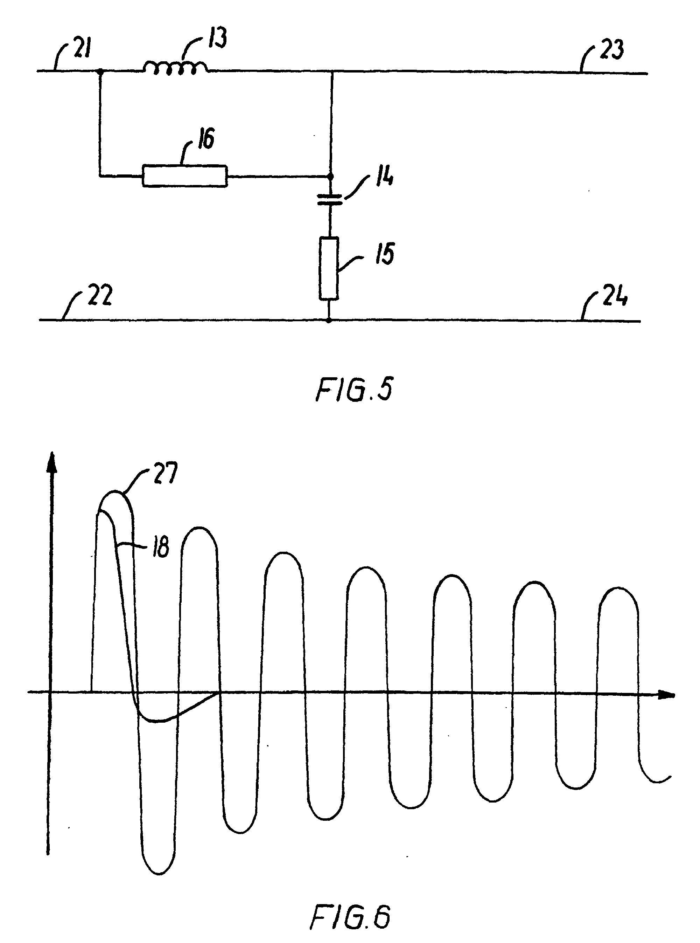

Figure 5 shows another example of how the circuit 1 may be realized as a two-port network, said two-port network being provided with a resistor 16 in parallel with the inductance 13 between the terminals 21 and 23.

When using this embodiment of the two-port network, the value of the resistor 15 may be increased, as the resistors 15 and 16 form a parallel coupling at high frequencies. Optionally, the resistor 15 may be selected to be infinitely great, so that the capacitor 14 and the resistor 15 may be omitted completely. The terminals 22 and 24 are interconnected.

Figure 6 shows a course of the ringings immediately after the switching of the terminal 7, with and without the circuit 1 connected to the terminals 5 and 6. The AC course of the ringings for the terminal 7 is shown at 27 without the circuit 1 connected, and at 18 with the circuit 1 connected to the terminals 5 and 6. It will be seen that the ringings 27 are slightly attenuated, and thereby constitute a relatively great part of the switching period, which causes distortion of the pulse height and electromagnetic radiation. On the other hand 18 shows a very attenuated course of the ringings, and the transient constitutes less than a period in practical realizations, which means that the pulse height distortion and the electromagnetic radiation are very low.

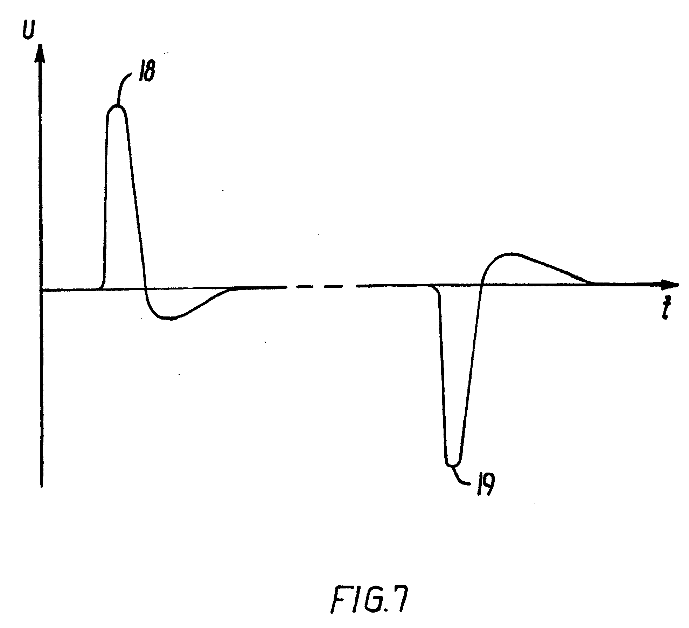

Figure 7, at 18, shows an example of the AC course of the voltage across the resistor 15 immediately after the switching of the terminal 7 from the terminal 6 to the terminal 5, where the current into the terminal 7 has a positive sign. If the value of the resistor is selected such that critical attenuation of the serial oscillation circuit is obtained in the switched circuit, a course of the same type as given at 18 is obtained. Thus it is shown at 18 how the voltage across the resistor 15 increases very rapidly to a peak value, which is predominantly determined by the value of the resistor 15, multiplied by the current in the terminal 7. The voltage decreases as the current is taken over by the inductance 13, and is zero after a short transient. With the same conditions, 19 shows a sequence where the terminal 7 is switched from the terminal 5 to the terminal 6, and it will be seen that the current in the inductance 13 is switched from running in the terminal 5 to run in the capacitor 14 and the resistor 15, whereby the voltage across the resistor 15 assumes a negative value, which is given by the product of the value of the resistor 15 and the current in the inductance at the switching moment. The voltage then increases toward zero as the current in the inductance 13 decreases, and is zero after a short transient.

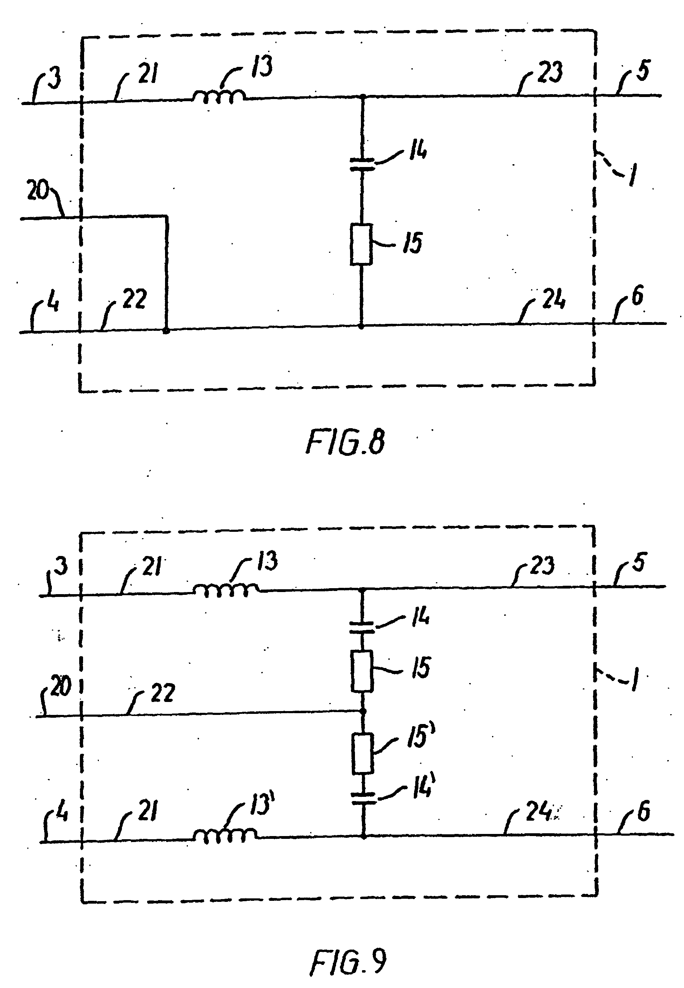

Figure 8 shows an example of how the circuit 1 may be realized with one two-port network as described in connection with figure 1 and 3. The terminals 21 and 22 of the two-port network are connected to the terminal 3 and the terminal 4, respectively, of the circuit 1, and the terminal 20 of the circuit is connected to the terminal 4. The terminals 23 and 24 of the two-port network are connected to the terminals 5 and 6, respectively, of the circuit.

Figure 9 shows another example of how the circuit 1 may be realized with two two-port networks, where the terminals 21 of the two-port networks are connected to the terminals 3 and 4, respectively, of the circuit 1, and where the terminals 22 of both two-port networks are connected to the terminal 20 of the circuit. The terminals 23 of the two-port networks are connected to the terminals 5 and 6, respectively, of the circuit.

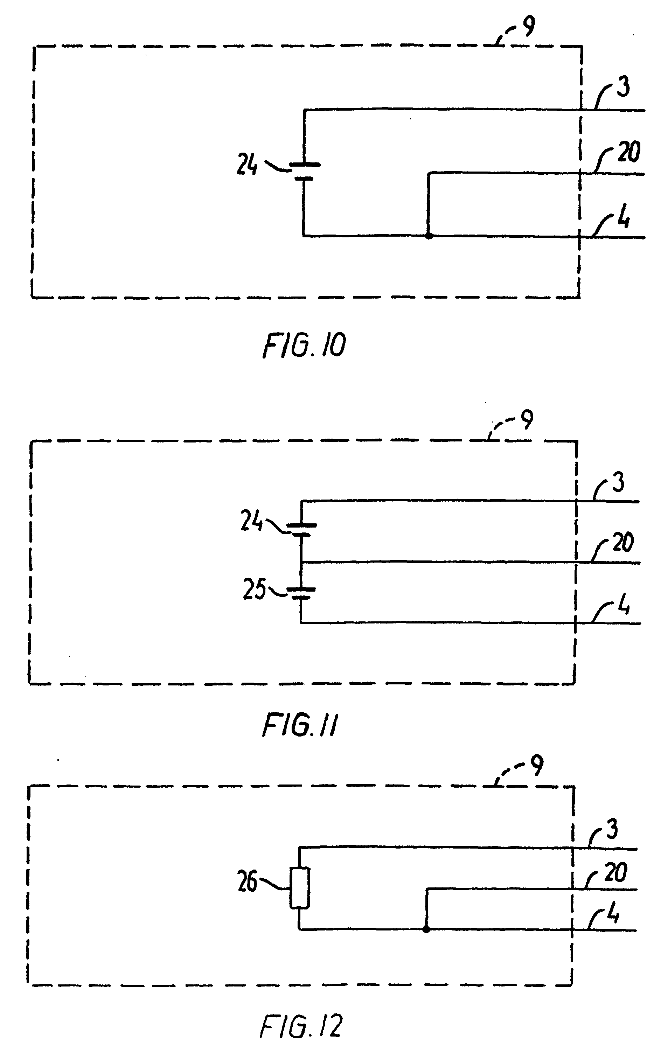

Figure 10 shows an example of how the circuit 9 may be realized with a single voltage supply 24, which is connected between the terminals 3 and 4 of the circuit 9, and where the terminal 20 is connected to the terminal 4.

Figure 11 shows a further example of how the circuit 9 may be realized with a double voltage supply given by 24 and 25, where the voltage supply 24 is connected to the terminals 3 and 20 of the circuit 9, and the voltage supply 25 is connected to the terminals 20 and 4 of the circuit 9.

Figure 12 shows an example of how the circuit 9 may be realized with a load 26 which is connected between the terminals 3 and 4, and where the terminal 20 is connected to the terminal 4.

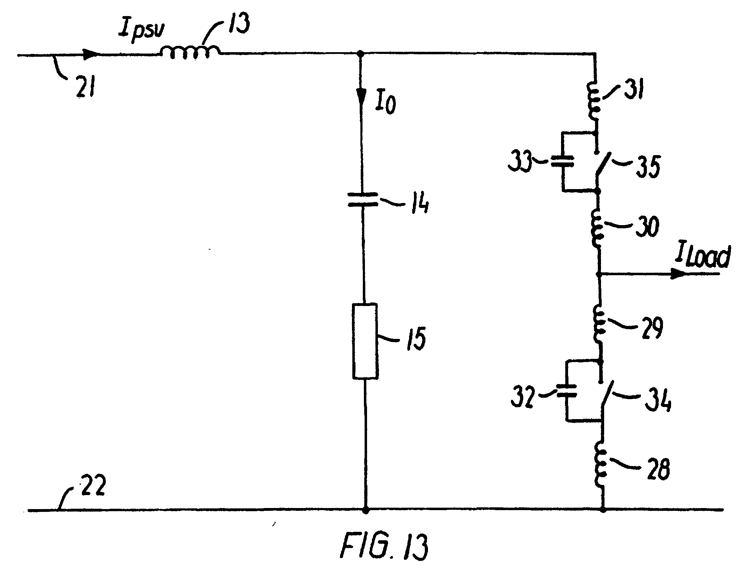

Figure 13 shows an example of how the circuits 1 and 2 on fig. 1 may be realised where the load can be connected between the terminals 7 and 8 and the power supply can be connected between the terminals 3 and 4.

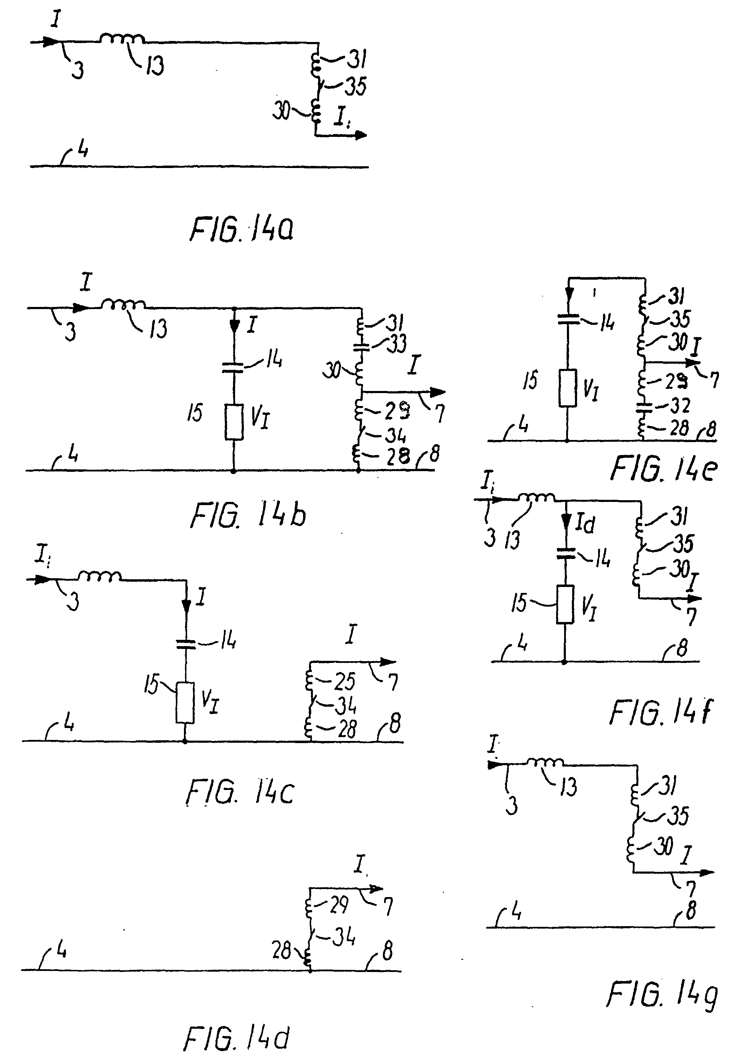

Figure 14a - 14g illustrates different current flow graphs of the circuit shown in figure 13 where the current flow graph is split into 6 states of the circuits 1 and 3.

Figure 14a shows a state where the switch 35 is conducting a positive load current and the current is running in the snubber inductor 13 and the two parasitic inductors 30 and 31.

Figure 14b shows the same circuits 1 and 3 where the switch 35 just have been switched off and the switch 34 just have been switched on, due to that the current running in the snubber inductor 13 and the currents running in the parasitic inductors 30 and 31 can not change simultaneously the currents will run in the capacitor 14 and the resistor 15 until the inductors 13, 30 and 31 contained energies is zero. In realisation of circuit 1 and 3 the inductor 13 will typically be chosen to have an inductance much greater than the parasitic inductance's together, which yields that the inductance 13 can be neglected at the resonance frequency of the parasitic components 28, 29, 30, 31, 32 and 33 and it is thereby seen that the resistor 15 damp's the ringings in the output stage.

Figure 14c shows the circuits 1 and 3 right after the energy in the parasitic inductors is zero and it is seen that load current is running through the switch 34 and its parasitic inductance's 28 and 29. Furthermore it is seen that the current that was in the inductor 13 still is running in the capacitor 14 and the resistor 15 until the energy in the inductor 13 is zero.

Figure 14d shows the circuits 1 and 3 in a state where the switching from switch 35 to switch 34 is finished and 34 is conducting a positive load current and the current is running in the switch 34 itself and in the two parasitic inductors 28 and 29.

Figure 14e shows the current flow in the circuit 1 and 3 under the switching of the load from switch 34 to switch 35 and it is seen that the current from the load is running in the capacitor 14 and the resistor 15 and that the resonant high frequency current running in the parasitic components 28, 29, 30 and 31 of the switches 34 and 35 also runs through the capacitor 14 and the resistor 15. The resonance frequency of the parasitic components 28, 29, 30, 31, 32 and 33 is thereby damped by the resistor 15.

Figure 14f shows the current flow in the circuit 1 and 3 after the switching from switch 34 to switch 35 is done and the load current is taken over from the capacitor 14 and the resistor 15 by the snubber inductor 13.

Figure 14g shows the following current flow of the circuits 1 and 3 and it is seen that the current flow is identical to that in figure 14a and thereby is the current flow graph completed.

Figure 15a shows the current flow diagram for circuit 1 and 3 at low frequencies when the load i.e. terminal 7 is switched to the power supply i.e. terminal 3, and it is seen that the current path strictly is given by the switch 35.

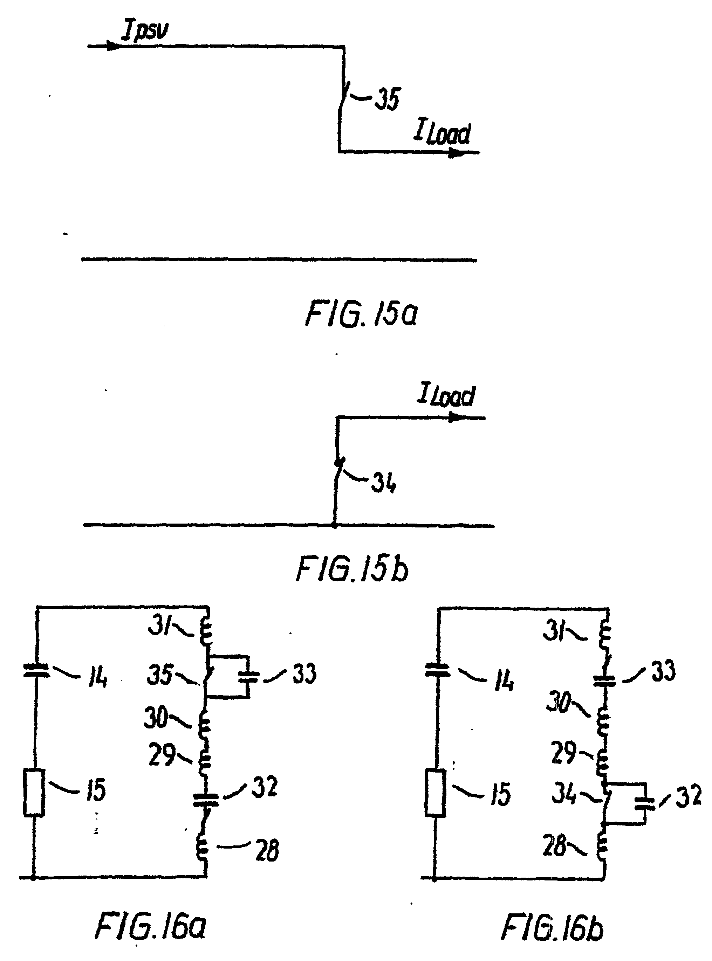

Figure 15b shows the current flow diagram for circuit 1 and 3 at low frequencies when the load i.e. terminal 7 is switched to the ground terminal 4, and it is seen that the current path strictly is given by the switch 34.

Figure 16a shows the current flow diagram for circuit 1 and 3 at very high frequencies, right after the load is switched from switch 34 to switch 35, and it is seen that the current running in the parasitic components 28, 29, 30, 31, 32 and 33 primarily is running in the capacitor 14 and the resistor 15, and with the right values of the capacitor 14 and the resistor 15, the oscillation circuit consisting of the parasitic components 28, 29, 30, 31, 32 and 33 can thereby be damped effectively by the resistor 15.

Figure 16b shows the current flow diagram for circuit 1 and 3 at very high frequencies, right after the load is switched from switch 35 to switch 34, and it is seen that the current running in the parasitic components 28, 29, 30, 31, 32 and 33 primarily is running in the capacitor 14 and the resistor 15, and with the right values of the capacitor 14 and the resistor 15, the oscillation circuit consisting of the parasitic components 28, 29, 30, 31, 32 and 33 can thereby be damped effectively by the resistor 15.

As will be appreciated from the foregoing, the invention provides a circuit with low losses which, in combination with a switched circuit of the two-port type, is capable of generating minimally distorted square-wave pulses with minimum noise and oscillations, and which is capable of limiting the peak current in the switches during the switching sequences, said circuit having a very low complexity.

## Claims

1. Use of a circuit comprising:
at least a correction circuit block (1) and a switching circuit block (2), said circuit blocks being of the two-port type, the switching circuit block (2) comprising a switchable port being capable of being switched between terminals (23,24) of the correction circuit block (1) at a switching frequency of a Class D audio amplifier, whereby the correction circuit block (1) has a short-circuit impedance which, seen from the switching circuit block, has a first value at said switching frequency and a second value which is predominantly resistive at a ringing frequency which is higher than said switching frequency and which occurs as a consequence of parasitic Inductances and capacities in the switching circuit block (2), the modulus of the first value being lower than the modulus of the second value
for reducing distortion and noise of square-wave pulses and for limiting peak currents, the square-wave pulses and the peak currents occurring during switching sequences in the switching circuit block (2).

2. A circuit comprising at least a correction circuit block (1) and a switching circuit block (2), said circuit blocks being of the two-port type, the switching circuit block (2) comprising a switchable port being capable of being switched between terminals (23,24) of the correction circuit block (1) at a switching frequency of a Class D audio amplifier, **characterised in that** the correction circuit block (1) has a short-circuit impedance which, seen from the switching circuit block, has a first value at said switching frequency and a second value which is predominantly resistive at a ringing frequency which is higher than said switching frequency and which occurs as a consequence of parasitic inductances and capacities in the switching circuit block (2), the modulus of the first value being lower than the modulus of the second value, so that the correction circuit block (1) constitutes a filter for reducing distortion and noise of square-wave pulses and for limiting peak currents, the square-wave pulses and the peak currents occurring as a consequence of switching sequences in the switching circuit block (2).

3. A circuit according to claim 2, wherein the switching circuit block (2) comprises:
- a first port comprising at least a first terminal (5) and a second terminal (6),
- a second port comprising at least a first terminal (7) and a second terminal (8),
- a switching terminal (17) which is connected to the first terminal (7) of the second port and adapted to be switched between the first terminal (5) and the second terminal (6) of the first port,
the correction circuit block (1) comprising:
- a first port comprising at least a first terminal (3,21) and a second terminal (4,22),
- a second port comprising a first terminal (23) and a second terminal (24), the first terminal (23) being connected to the first terminal (3,21) of the first port via a first inductive component (13), the second terminal (24) being connected to the second terminal (4,22) of the first port,
- a first capacitive component (14) and
- a first resistive component (15), the first capacitive component (14) and the first resistive component (15) being arranged in series between the first (23) and second (24) terminals of the second port to form a first series connection,
thereby providing said short-circuit Impedance between the terminals (23,24) of the second port,
the first terminal (23) of the second port of the correction circuit block (1) being connected to the first terminal (5) of the first port of the switching circuit block (2), the second (24) terminal of the second port of the correction circuit block (1) being connected to the second (6) terminal of the first port of the switching circuit block (2).

4. A circuit according to claim 3, wherein the first port of the correction circuit block (1) further comprises:
- a third terminal (20),
- a second inductive component (13'),
- a second capacitive component (14') and
- a second resistive component (15'),
wherein, in the correction circuit block (1):
- the second inductive component (13') is arranged between the second terminal (4) of the first port and the second terminal (24) of the second port,
- the second capacitive component (14') and the second resistive component (15') are arranged in series with the first capacitive (14) and resistive (15) components between the first (23) and second (24) terminals of the second port to form a second series connection,
- the third terminal (20) is connected to a point between the first and the second series connection.

5. A circuit according to claim 3, wherein the correction circuit block (1) further comprises a third resistive component (16) which is connected in parallel with the first inductive component (13).

6. A circuit according to any of the preceding claims, wherein the values of the capacitive and inductive components of the correction circuit block (1) are at least four times greater than the values of the parasitic capacitive and inductive components of the switching circuit block (2).

7. A circuit according to any of the preceding claims, where the correction circuit block (1) and the switching circuit block (2) are formed as an integrated unit on a substrate.

8. A circuit according to claim 7, wherein a conductor path on the substrate forms the inductive component (13).

9. A circuit according to any of the preceding claims, wherein the first and/or second series connection of the capacitive (14,14') and resistive (15,15') component or components is/are formed by the internal resistance of the capacitive component or components.

10. A class D audio amplifier comprising a circuit according to any of claims 2-9.

## Patentansprüche

1. Verwendung einer Schaltung, die folgendes umfaßt:
wenigstens einen Korrektur-Schaltungsblock (1) und einen Umschalt-Schaltungsblock (2), wobei die Schaltungsblöcke von der Art eines Zwei-Ports sind, wobei der Umschalt-Schaltungsblock (2) einen schaltbaren Port umfaßt, der zwischen Anschlüssen (23, 24) des Korrektur-Schaltungsblocks (1) bei einer Schaltfrequenz eines Klasse-D-Audioverstärkers geschaltet werden kann, wobei der Korrektur-Schaltungsblock (1) eine Kurzschlußimpedanz aufweist, die, vom Umschalt-Schaltungsblock aus gesehen, bei der Schaltfrequenz einen ersten Wert aufweist und bei einer Überschwingfrequenz, die höher als die Schaltfrequenz ist und die als Folge der parasitären Induktivitäten und Kapazitäten in dem Umschalt-Schaltungsblock (2) auftritt, einen zweiten Wert aufweist, der überwiegend widerstandsbehaftet ist, wobei der Betrag des ersten Wertes kleiner als der Betrag des zweiten Wertes ist,
zur Verringerung von Verzerrungen und Rauschen von Rechteckwellenimpulsen und zur Begrenzung von Spitzenströmen, wobei die Rechteckwellenimpulse und die Spitzenströme während Schaltfolgen im Umschalt-Schaltungsblock (2) auftreten.

2. Schaltung, die wenigstens einen Korrektur-Schaltungsblock (1) und einen Umschalt-Schaltungsblock (2) umfaßt, wobei die Schaltungsblöcke von der Art eines Zwei-Ports sind, der Umschalt-Schaltungsblock (2) einen schaltbaren Port umfaßt, der zwischen Anschlüssen (23, 24) des Korrektur-Schaltungsblocks (1) bei einer Schaltfrequenz eines Klasse-D-Audioverstärkers geschaltet werden kann, **dadurch gekennzeichnet, daß** der Korrektur-Schaltungsblock (1) eine Kurzschlußimpedanz aufweist, die, vom Umschalt-Schaltungsblock aus gesehen, bei der Schaltfrequenz einen ersten Wert aufweist und bei einer Überschwingfrequenz, die höher als die Schaltfrequenz ist und die als Folge der parasitären Induktivitäten und Kapazitäten in dem Umschalt-Schaltungsblock (2) auftritt, einen zweiten Wert aufweist, der überwiegend widerstandsbehaftet ist,
wobei der Betrag des ersten Wertes kleiner als der Betrag des zweiten Wertes ist, so daß der Korrektur-Schaltungsblock (1) ein Filter zur Verringerung von Verzerrungen und Rauschen von Rechteckwellenimpulsen und zur Begrenzung von Spitzenströmen bildet, wobei die Rechteckwellenimpulse und die Spitzenströme während Schaltfolgen im Umschalt-Schaltungsblock (2) auftreten.

3. Schaltung nach Anspruch 2, bei der der Umschalt-Schaltungsblock (2) folgendes umfaßt:
- einen ersten Anschluß, der wenigstens einen ersten Anschluß (5) und einen zweiten Anschluß (6) umfaßt,
- einen zweiten Anschluß, der wenigstens einen ersten Anschluß (7) und einen zweiten Anschluß (8) umfaßt,
- einen Schaltanschluß (17), der mit dem ersten Anschluß (7) des zweiten Ports verbunden ist und der dazu ausgelegt ist, zwischen dem ersten Anschluß (5) und dem zweiten Anschluß (6) des ersten Ports umgeschaltet zu werden,
wobei der Korrektur-Schaltungsblock (1) folgendes umfaßt:
- einen ersten Anschluß, der wenigstens einen ersten Anschluß (3,21) und einen zweiten Anschluß (4,22) umfaßt,
- einen zweiten Anschluß, der einen ersten Anschluß (23) und einen zweiten Anschluß (24) umfaßt, wobei der erste Anschluß (23) mit dem ersten Anschluß (3,21) des ersten Ports über ein erstes induktives Bauteil (13) verbunden ist und der zweite Anschluß (24) mit dem zweiten Anschluß (4,22) des ersten Ports verbunden ist,
- ein erstes kapazitives Bauteil (14) und
- ein erstes widerstandsbehaftetes Bauteil (15), wobei das erste kapazitive Bauteil (14) und das erste widerstandsbehaftete Bauteil (15) in Serie zwischen dem ersten Anschluß (23) und dem zweiten Anschluß (24) des zweiten Ports angeordnet sind, um eine erste Reihenschaltung zu bilden, wodurch die Kurzschlußimpedanz zwischen den Anschlüssen (23,24) des zweiten Ports bereitgestellt wird,
wobei der erste Anschluß (23) des zweiten Ports des Korrektur-Schaltungsblocks (1) mit dem ersten Anschluß (5) des ersten Ports des Umschalt-Schaltungsblocks (2) verbunden ist und der zweite Anschluß (24) des zweiten Ports des Korrektur-Schaltungsblocks (1) mit dem zweiten Anschluß (6) des ersten Ports des Umschalt-Schaltungsblocks (2) verbunden ist.

4. Schaltung nach Anspruch 3, bei der der erste Port des Korrektur-Schaltungsblocks (1) darüber hinaus umfaßt:
- einen dritten Anschluß (20),
- ein zweites induktives Bauteil (13'),
- ein zweites kapazitives Bauteil (14') und
- ein zweites widerstandsbehaftetes Bauteil (15'),
bei der im Korrektur-Schaltungsblock (1):
- das zweite induktive Bauteil (13') zwischen dem zweiten Anschluß (4) des ersten Ports und dem zweiten Anschluß (24) des zweiten Ports angeordnet ist,
- das zweite kapazitive Bauteil (14') und das zweite widerstandsbehaftete Bauteil (15') in Serie mit dem ersten kapazitiven Bauteil (14) und dem ersten widerstandsbehafteten Bauteil (15) zwischen dem ersten Anschluß (23) und dem zweiten Anschluß (24) des zweiten Ports angeordnet sind, um eine zweite Reihenschaltung zu bilden,
- der dritte Anschluß (20) mit einem Punkt zwischen der ersten und der zweiten Reihenschaltung verbunden ist.

5. Schaltung nach Anspruch 3, bei der der Korrektur-Schaltungsblock (1) darüber hinaus ein drittes widerstandsbehaftetes Bauteil (16) umfaßt, das parallel zum ersten induktiven Bauteil (13) angeschlossen ist.

6. Schaltung nach einem der vorherigen Ansprüche, bei der die Werte der kapazitiven und induktiven Bauteile des Korrektur-Schaltungsblocks (1) wenigstens viermal größer sind als die Werte der parasitären kapazitiven und induktiven Bauteile des Umschalt-Schaltungsblocks (2).

7. Schaltung nach einem der vorherigen Ansprüche, bei der der Korrekturschaltungsblock (1) und der Umschalt-Schaltungsblock (2) als eine integrierte Einheit auf einem Substrat gebildet sind.

8. Schaltung nach Anspruch 7, bei der ein Leitungspfad auf dem Substrat das induktive Bauteil (13) bildet.

9. Schaltung nach einem der vorherigen Ansprüche, bei der die erste und/oder zweite Reihenschaltung des/der kapazitiven (14,14') und widerstandsbehafteten (15,15') Bauteils/Bauteile durch den internen Widerstand des/der kapazitiven Bauteils/Bauteile gebildet wird/werden.

10. Klasse-D-Audioverstärker, der eine Schaltung nach einem der Ansprüche 2 bis 9 umfaßt.

## Revendications

1. Utilisation d'un circuit comprenant :
au moins un bloc de circuit de correction (1) et un bloc de circuit de commutation (2), lesdits blocs de circuits étant du type à deux ports, le bloc de circuit de commutation (2) comprenant un port commutable pouvant être commuté entre les bornes (23, 24) du bloc de circuit de correction (1) à une fréquence de commutation d'un amplificateur audio de classe D, moyennant quoi le bloc de circuit de correction (1) a une impédance de court-circuit qui, vue du bloc de circuit de commutation, a une première valeur à ladite fréquence de commutation et une deuxième valeur principalement résistive à une fréquence d'oscillation supérieure à ladite fréquence de commutation, et qui se produit par suite d'inductances et de capacités parasites dans le bloc de circuit de commutation (2), le module de la première valeur étant inférieur au module de la deuxième valeur afin de réduire la distorsion et le bruit des impulsions de signaux carrés et de limiter les courants de pointe, les impulsions de signaux carrés et les courants de pointe se produisant suite aux séquences de commutation dans le bloc de circuit de commutation (2).

2. Circuit comprenant au moins un bloc de circuit de correction (1) et un bloc de circuit de commutation (2), lesdits blocs de circuits étant du type à deux ports, le bloc de circuit de commutation (2) comprenant un port commutable pouvant être commuté entre les bornes (23, 24) du bloc de circuit de correction (1) à une fréquence de commutation d'un amplificateur audio de classe D **caractérisé en ce que** le bloc de circuit de correction (1) a une impédance de court-circuit qui, vue du bloc de circuit de commutation, a une première valeur à ladite fréquence de commutation et une deuxième valeur principalement résistive à une fréquence d'oscillation supérieure à ladite fréquence de commutation, qui se produit par suite d'inductances et de capacités parasites dans le bloc de circuit de commutation (2), le module de la première valeur étant inférieur au module de la deuxième valeur, de sorte que le bloc de circuit de correction (1) constitue un filtre pour réduire la distorsion et le bruit des impulsions de signaux carrés et pour limiter les courants de pointe, les impulsions de signaux carrés et les courants de pointe se produisant suite aux séquences de commutation dans le bloc de circuit de commutation (2).

3. Circuit selon la revendication 2, dans lequel le bloc de circuit de commutation (2) comprend :
- un premier port comprenant au moins une première borne (5) et une deuxième borne (6),
- un deuxième port comprenant au moins une première borne (7) et une deuxième borne (8),
- une borne de commutation (17) reliée à la première borne (7) du deuxième port et adaptée pour être commutée entre la première borne (5) et la deuxième borne (6) du premier port,
le bloc de circuit de correction (1) comprenant :
- un premier port comprenant au moins une première borne (3, 21) et une deuxième borne (4, 22),
- un deuxième port comprenant une première borne (23) et une deuxième borne (24), la première borne (23) étant reliée à la première borne (3, 21) du premier port par l'intermédiaire d'un premier composant inductif (13), la deuxième borne (24) étant reliée à la deuxième borne (4,22) du premier port,
- un premier composant capacitif (14) et
- un premier composant résistif (15), le premier composant capacitif (14) et le premier composant résistif (15) étant organisés en série entre la première borne (23) et la seconde borne (24) du deuxième port pour former une première connexion série, formant ainsi l'impédance de court-circuit entre les bornes (23, 24) du deuxième port,
la première borne (23) du deuxième port du bloc de circuit de correction (1) étant reliée à la première borne (5) du premier port du bloc de circuit de commutation (2), la deuxième borne (24) du deuxième port du bloc de circuit de correction (1) étant reliée à la deuxième borne (6) du premier port du bloc de circuit de commutation (2).

4. Circuit selon la revendication 3, dans lequel le premier port du bloc de circuit de correction (1) comprend par ailleurs :
- une troisième borne (20),
- un deuxième composant inductif(13'),
- un deuxième composant capacitif(14') et
- un deuxième composant résistif (15'),
dans lequel, dans le bloc de circuit de correction (1) :
- le deuxième composant inductif (13') est organisé entre la deuxième borne (4) du premier port et la deuxième borne (24) du deuxième port,
- le deuxième composant capacitif (14') et le deuxième composant résistif (15') sont organisés en série avec le premier composant capacitif (14) et le premier composant résistif (15) entre la première borne (23) et la deuxième borne (24) du deuxième port pour former une deuxième connexion en série,
- la troisième borne (20) est reliée à un point entre la première et la deuxième connexion en série.

5. Circuit selon la revendication 3, dans lequel le bloc de circuit de correction (1) comprend en outre un troisième composant résistif (16) qui est relié parallèlement au premier composant inductif (13).

6. Circuit selon l'une quelconque des revendications précédentes, dans lequel les valeurs des composants capacitifs et inductifs du bloc de circuit de correction (1) sont au moins quatre fois supérieures aux valeurs des composants capacitifs et inductifs parasites du bloc de circuit de commutation (2).

7. Circuit selon l'une quelconque des revendications précédentes, dans lequel le bloc de circuit de correction (1) et le bloc de circuit de commutation (2) sont formés comme une unité intégrée sur un substrat.

8. Circuit selon la revendication 7, dans lequel un chemin conducteur sur le substrat forme le composant inductif (13).

9. Circuit selon l'une quelconque des revendications précédentes, dans lequel la première et/ou la deuxième connexion en série du composant ou des composants capacitifs (14, 14') et du composant ou des composants résistifs (15, 15') sont constituées par la résistance interne du composant ou des composants capacitifs.

10. Classe d'amplificateur D audio comprenant un circuit selon l'une quelconque des revendications 2 à 9.
